(19) Europäisches Patentamt / European Patent Office / Office européen des brevets

(11) **EP 3 528 391 B1**

(12) **FASCICULE DE BREVET EUROPEEN**

(45) Date de publication et mention
de la délivrance du brevet:
**15.09.2021 Bulletin 2021/37**

(21) Numéro de dépôt: **19155842.8**

(22) Date de dépôt: **06.02.2019**

(51) Int Cl.:
*H04B 5/02* *(2006.01)*      *H03F 3/68* *(2006.01)*
*H04B 5/00* *(2006.01)*      *H04B 1/04* *(2006.01)*
*H03F 3/20* *(2006.01)*      *H03F 3/21* *(2006.01)*
*H03F 3/24* *(2006.01)*

(54) **CONTRÔLEUR NFC**

NFC STEUREINHEIT

NFC CONTROLLER

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **15.02.2018 FR 1851271**

(43) Date de publication de la demande:
**21.08.2019 Bulletin 2019/34**

(73) Titulaire: **STMICROELECTRONICS (ROUSSET)
SAS
13790 Rousset (FR)**

(72) Inventeur: **CORDIER, Nicolas
13080 AIX-EN-PROVENCE (FR)**

(74) Mandataire: **Cabinet Beaumont
4, Place Robert Schuman
B.P. 1529
38025 Grenoble Cedex 1 (FR)**

(56) Documents cités:
**EP-A2- 2 690 779      US-A1- 2009 201 084**

## Description

Domaine

La présente description concerne de façon générale les circuits électroniques et, plus particulièrement, les dispositifs électroniques intégrant un circuit de communication en champ proche (NFC - Near Field Communication).

État de l'art antérieur

Les systèmes de communication en champ proche sont de plus en plus fréquents et on les retrouve dans de nombreuses applications.

Ces systèmes exploitent un champ électromagnétique radiofréquence émis par un dispositif (terminal ou lecteur) pour communiquer avec un autre dispositif (carte).

Selon les applications, un dispositif NFC ne communique qu'en mode carte ou un même dispositif NFC peut opérer en mode carte ou en mode lecteur (par exemple dans le cas d'une communication en champ proche entre deux téléphones mobiles).

Lorsqu'il fonctionne en mode lecteur, un dispositif génère un champ électromagnétique radiofréquence destiné à être capté par des dispositifs à portée (fonctionnant en mode carte).

Lorsqu'il fonctionne en mode carte, un dispositif NFC capte un champ électromagnétique radiofréquence généré par un dispositif opérant en mode lecteur. Certains dispositifs (essentiellement les dispositifs dits à modulation de charge passive) prélèvent l'énergie nécessaire à leur fonctionnement du champ rayonné par un lecteur à portée duquel ils se trouvent et rétromodulent le champ du terminal. D'autres dispositifs (à modulation de charge active) possèdent leur propre source d'énergie afin d'être capables d'émettre un signal pour répondre au lecteur de façon synchronisée avec celui-ci.

La présente description vise plus particulièrement un contrôleur NFC à modulation active. Un dispositif NFC équipé d'un tel contrôleur comporte une ou plusieurs antennes.

Le document US 2009/201084 décrit des amplificateurs de puissance multimodes pouvant supporter plusieurs technologies radio et/ou plusieurs bandes de fréquences.

Résumé

Un mode de réalisation pallie tout ou partie des inconvénients des dispositifs NFC usuels.

Un mode de réalisation propose un contrôleur NFC adapté à deux antennes.

Un mode de réalisation propose une solution adaptée à un dispositif NFC capable de fonctionner en mode carte et en mode lecteur.

Un mode de réalisation prévoit un circuit d'amplification comportant deux groupes d'un même nombre d'amplificateurs, des sorties d'amplificateurs d'un premier groupe étant interconnectées à une première borne, des sorties d'amplificateurs d'un deuxième groupe étant réparties en deux sous-ensembles respectivement interconnectés à des deuxième et troisième bornes.

Selon un mode de réalisation, chaque groupe d'amplificateurs est identique.

Selon un mode de réalisation, les amplificateurs d'un même groupe sont de puissances différentes.

Selon un mode de réalisation, les deux sous-ensembles d'amplificateurs du deuxième groupe sont de puissances différentes.

Selon un mode de réalisation, les amplificateurs du premier groupe sont commandables ensemble, les amplificateurs des deux sous-ensembles du deuxième groupe étant soit commandables ensemble, soit commandables séparément, l'un des sous-ensembles étant alors commandé avec le premier groupe d'amplificateurs.

Selon un mode de réalisation, chaque amplificateur est de classe D.

Un mode de réalisation prévoit un contrôleur NFC comportant au moins un circuit d'amplification.

Selon un mode de réalisation, le contrôleur comporte deux sorties, dans lequel le rapport entre les puissances respectives fournies par les deux sorties est de 1 si les deuxième et troisième bornes du circuit d'amplification sont interconnectées et est différent de 1 si les première et deuxième bornes du circuit d'amplification sont interconnectées.

Un mode de réalisation prévoit un circuit d'émissionréception NFC comportant un contrôleur.

Selon un mode de réalisation, le circuit d'émissionréception NFC comporte :

un circuit d'adaptation d'impédance ; et
une antenne à entrées différentielles.

Selon un mode de réalisation, les deuxième et troisième bornes du circuit d'amplification sont interconnectées.

Selon un mode de réalisation, le circuit d'émissionréception NFC comporte :

deux circuits d'adaptation d'impédance ; et
deux antennes ayant chacune une entrée non-différentielle et une borne reliée à une masse.

Selon un mode de réalisation, les première et deuxième bornes du circuit d'amplification sont interconnectées.
Un mode de réalisation prévoit un dispositif NFC comportant au moins un circuit d'émission-réception NFC.

Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

la figure 1 est une représentation très schématique et sous forme de blocs d'un exemple de système de communication en champ proche du type auquel s'appliquent des modes de réalisation qui vont être décrits ;
la figure 2 représente, de façon très schématique et sous forme de blocs, un mode de réalisation d'un contrôleur NFC ;
la figure 3 représente, de façon très schématique et sous forme de blocs, un mode de réalisation d'un circuit d'amplification ;
la figure 4 représente, de façon très schématique et sous forme de blocs, un exemple de raccordement d'un contrôleur NFC dans un dispositif à deux antennes respectivement dédiées au mode lecteur et au mode carte ;
la figure 5 représente, de façon très schématique et sous forme de blocs, un exemple de raccordement d'un contrôleur NFC dans un dispositif à une antenne différentielle ; et
la figure 6 représente un mode de réalisation d'un circuit d'amplification à plusieurs amplificateurs élémentaires.

Description détaillée

De mêmes éléments ont été désignés par de mêmes références aux différentes figures. En particulier, les éléments structurels et/ou fonctionnels communs aux différents modes de réalisation peuvent présenter les mêmes références et peuvent disposer de propriétés structurelles, dimensionnelles et matérielles identiques.
Par souci de clarté, seuls les étapes et éléments utiles à la compréhension des modes de réalisation décrits ont été représentés et sont détaillés. En particulier, la génération des signaux radiofréquence et leur interprétation n'ont pas été détaillées, les modes de réalisation décrits étant compatibles avec les techniques usuelles de génération et d'interprétation de ces signaux.
Sauf précision contraire, lorsque l'on fait référence à deux éléments connectés entre eux, cela signifie directement connectés sans élément intermédiaire autre que des conducteurs, et lorsque l'on fait référence à deux éléments reliés ou couplés entre eux, cela signifie que ces deux éléments peuvent être directement reliés (connectés) ou reliés par l'intermédiaire d'un ou plusieurs autres éléments.
Dans la description qui suit, lorsque l'on fait référence aux termes "approximativement", "environ" et "de l'ordre de", cela signifie à 10 % près, de préférence à 5 % près.

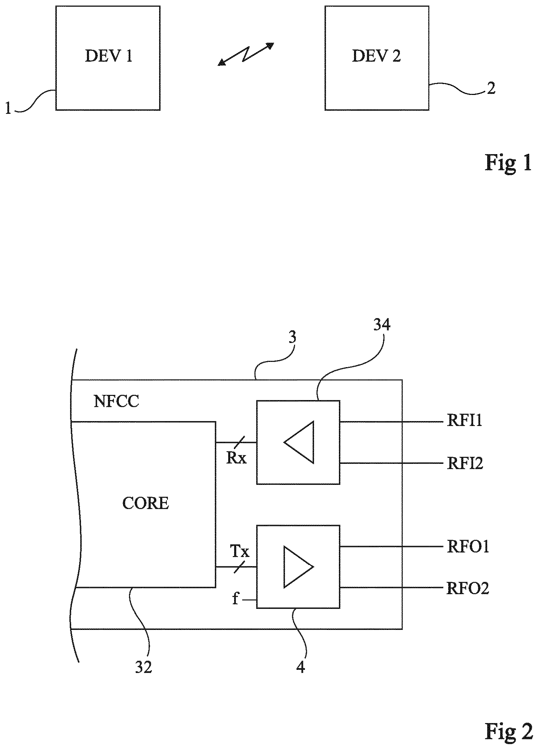

La figure 1 est une représentation très schématique et sous forme de blocs d'un exemple de système de communication en champ proche du type auquel s'appliquent des modes de réalisation qui vont être décrits.
On suppose le cas de deux dispositifs électroniques similaires, par exemple deux téléphones mobiles, mais tout ce qui va être décrit s'applique plus généralement à tout système dans lequel un transpondeur capte un champ électromagnétique rayonné par un lecteur, borne ou terminal. Pour simplifier, on fera référence à des dispositifs NFC pour designer des dispositifs électroniques intégrant des circuits de communication en champ proche.
Deux dispositifs NFC 1 (DEV1) et 2 (DEV2) sont susceptibles de communiquer par couplage électromagnétique en champ proche. Selon les applications, pour une communication, un des dispositifs fonctionne en mode dit lecteur tandis que l'autre fonctionne en mode dit carte, ou les deux dispositifs communiquent en mode poste à poste (peer to peer - P2P). Chaque dispositif comporte divers circuits électroniques de génération d'un signal radiofréquence émis à l'aide d'une ou plusieurs antennes. Le champ radiofréquence généré par l'un des dispositifs est capté par l'autre dispositif qui se trouve à portée et qui comporte également une ou plusieurs antennes.
On fera par la suite référence à un dispositif à modulation de charge active, c'est-à-dire émettant un signal radiofréquence en mode lecteur et en mode carte. On notera toutefois que chaque dispositif 1 ou 2 peut également, en mode lecteur, communiquer avec une carte à modulation de charge passive (rétro modulation résistive ou capacitive).
Un dispositif NFC comporte un ou plusieurs circuits oscillants constitués chacun d'une antenne (élément inductif) et d'un élément capacitif pour capter ou émettre un champ électromagnétique. En mode lecteur ou terminal, le ou les circuits oscillants sont excités par un signal radiofréquence produit par des circuits électroniques (contrôleur NFC) du dispositif pour générer un champ et moduler ce champ en fonction des informations à transmettre. En mode carte, le contrôleur NFC extrait du champ électromagnétique qu'il capte et qui provient d'un lecteur la fréquence de la porteuse (typiquement 13,56 MHz) et les données transmises par le lecteur, et transmet de façon synchronisée des données en modulation de charge active à ce lecteur, en émettant un signal synchronisé avec celui du lecteur et en le modulant au rythme d'une sous-porteuse.

Les contrôleurs NFC sont réalisés sous forme de circuits intégrés qui génèrent des signaux radiofréquence en mode différentiel et sont adaptés à recevoir des signaux radiofréquence différentiels.

Cela nécessite habituellement d'intercaler divers circuits entre le contrôleur NFC et la ou les antennes en fonction de l'architecture du dispositif en termes de circuits oscillants. En particulier, si certains dispositifs utilisent une seule antenne attaquée par un signal différentiel, d'autres utilisent une antenne cadre ou non-différentielle (single-ended). Dans ce dernier cas, on souhaite parfois utiliser des antennes différentes selon le mode de fonctionnement (carte ou lecteur) afin de pouvoir optimiser la taille de l'antenne utilisée en fonction du mode concerné. Plus particulièrement, les besoins en énergie sont généralement différents en mode carte et en mode lecteur. En mode carte, une antenne de taille relativement restreinte (par rapport à l'antenne utilisée en mode lecteur) suffit dans la mesure où, lorsque l'on émet en mode carte, c'est que l'on est dans le champ d'un lecteur et le besoin d'énergie est donc moindre. En mode lecteur au contraire, on souhaite généralement une plus grande portée, ce qui engendre un besoin d'une plus grande antenne et d'un besoin d'énergie plus important (également pour pouvoir téléalimenter des cartes à modulation de charge passive). Typiquement, dans le cas de téléphones mobiles équipés de contrôleurs NFC, une antenne de (relative) faible taille du type de celles utilisées dans les téléphones pour les communications GSM suffit pour le mode carte. Toutefois, cette antenne est insuffisante pour le mode lecteur qui requiert une antenne de plus grande taille. Réutiliser l'antenne servant également aux communications téléphoniques présente l'avantage de ne pas avoir besoin d'une antenne supplémentaire.

Ainsi, hormis des réseaux d'adaptation d'impédance (matching circuits), on est souvent contraint d'intercaler, entre le contrôleur NFC et la ou les antennes, divers transformateurs à changement de mode (baluns), séparateurs (splitters), commutateurs (switches), etc., qui sont encombrants car au moins partiellement formés de composants discrets.

Les modes de réalisation décrits proposent une nouvelle approche de contrôleur NFC compatible avec différentes architectures de circuits oscillants, sans qu'il soit nécessaire d'utiliser un balun ou des commutateurs et séparateurs d'antennes.

Plus particulièrement, on propose un contrôleur NFC pouvant être monté dans un dispositif utilisant une même antenne différentielle (attaquée par un signal différentiel en émission et recevant un signal différentiel en réception) en mode lecteur et en mode carte, ou dans un dispositif utilisant deux antennes différentes, l'une pour le mode carte et l'autre pour le mode lecteur (attaquées chacune en émission par un signal non différentiel et recevant en réception un signal non différentiel).

La figure 2 représente, de façon très schématique et sous forme de blocs, un mode de réalisation d'un contrôleur NFC 3 (NFCC).

Le contrôleur 3 comporte divers circuits 32 de traitement numériques (CORE) destinés à recevoir des informations à transmettre provenant d'autres circuits du dispositif et à transmettre à ces autres circuits des informations provenant d'autres dispositifs. Le contrôleur 3 comporte deux bornes RFI1 et RFI2 d'entrée et deux bornes RFO1 et RFO2 de sortie, destinées à être couplées à la ou les antennes selon le dispositif dans lequel il est monté. Les bornes RFI1 et RFI2 sont couplées à un circuit 34 de réception comportant, outre des circuits d'amplification des signaux reçus, un démodulateur de ces signaux reçus. Le circuit 34 fournit un ou plusieurs signaux démodulés Rx au coeur numérique 32. Les bornes RFO1 et RFO2 reçoivent des signaux radiofréquence d'un circuit 4 d'émission qui module une porteuse radiofréquence f en fonction de données Tx qu'il reçoit du coeur numérique 32. Le circuit 4 comporte des amplificateurs (drivers) amplifiant les signaux à transmettre. Pour simplifier, les autres circuits usuels du contrôleur 3 et les signaux d'alimentation des différents circuits ne sont pas représentés en figure 2.

En mode lecteur, les bornes RFO1 et RFO2 transmettent l'énergie et les données vers un dispositif en mode carte. Il peut s'agir d'un dispositif à modulation de charge active ou à modulation de charge passive. Les bornes RFI1 et RFI2 reçoivent les données en provenance du dispositif en mode carte.

En mode carte, les bornes RFI1 et RFI2 permettent de récupérer l'horloge de la porteuse du lecteur et les données émises par celui-ci. Les bornes RFO1 et RFO2 permettent de transmettre des données dans le sens carte vers lecteur par modulation de charge active.

Le contrôleur 3 peut être monté dans un dispositif soit avec ces deux bornes RFO1 et RFO2 couplées à une antenne à attaquer par des signaux différentiels (les signaux étant en opposition de phase), ou à deux antennes attaquées par des signaux non différentiels.

Pour cela, on prévoit une structure particulière des amplificateurs du circuit 4 et de leurs raccordements aux bornes RFO1 et RFO2.

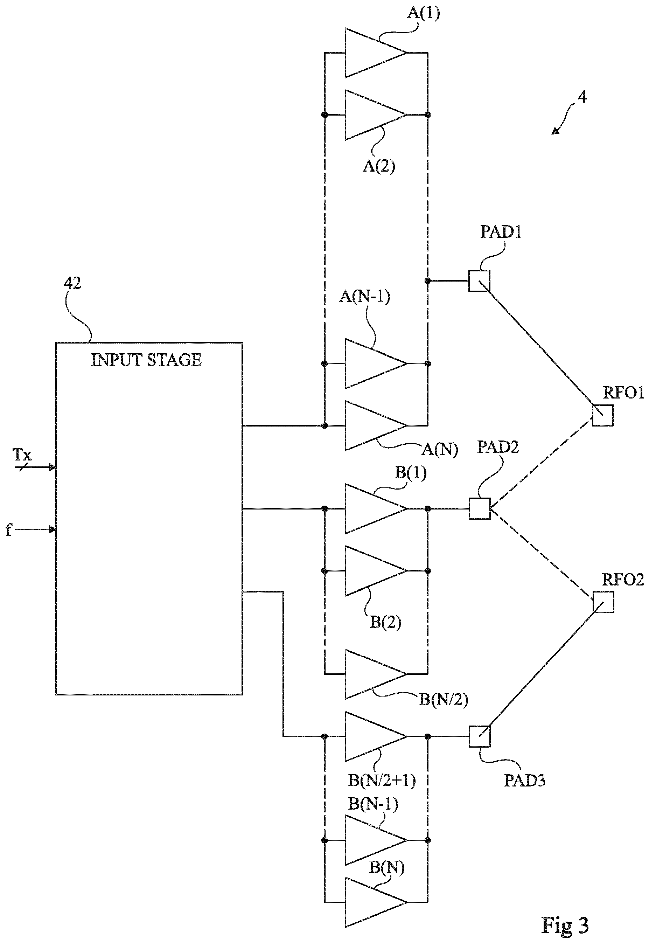

La figure 3 représente, de façon très schématique et sous forme de blocs, un mode de réalisation d'un circuit d'amplification 4 et de son raccordement aux bornes RFO1 et RFO2.

On prévoit de réaliser le circuit d'amplification d'émission 4 sous la forme de deux groupes A et B comportant chacun un même nombre N (au moins deux) d'amplificateurs élémentaires A(i), respectivement B(i), (i allant de 1 à N). De préférence, les N amplificateurs élémentaires de chaque groupe sont de poids différents, c'est-à-dire que les N amplificateurs d'un groupe présentent chacun une résistance différente, donc fournissent chacun une puissance différente. De préférence, on prévoit une pondération binaire, c'est-à-dire que la résistance d'un amplificateur de rang i représente le double de la résistance de l'amplificateur de rang i-1 et la moitié de la résistance de l'amplificateur de rang i+1. En d'autres termes, plus le rang i de l'amplificateur est faible plus il contribue pour une puissance importante dans l'émission.

De plus, on prévoit d'interconnecter différemment les sorties des amplificateurs selon que le contrôleur 3 est connecté à un système à une antenne différentielle ou à un système à deux antennes non différentielles.

Pour une connexion à une antenne différentielle, on souhaite que chaque borne de l'antenne reçoive la même puissance de la borne RFO1 et de la borne RFO2, en pratique des signaux de même amplitude mais en opposition de phase. Par conséquent, il faut que le nombre d'amplificateurs élémentaires couplés à chaque antenne soit le même et que chaque groupe comporte la même distribution de puissances élémentaires. C'est pourquoi on utilise un nombre 2N pair d'amplificateurs au total et que les deux groupes A et B sont identiques en termes de distribution de pondération des différents amplificateurs élémentaires qu'ils comportent. Dans l'exemple de la figure 3, le nombre N est également pair mais il pourrait en variante être impair.

Les sorties des N amplificateurs A(i) du groupe A sont interconnectées à un plot PAD1. Par ailleurs, les sorties des N amplificateurs B(i) du groupe B sont interconnectées par sous-ensembles. Comme le montre l'exemple de la figure 3, on prévoit une interconnexion par moitié (N étant pair). Chaque sous-ensemble comporte des amplificateurs de rangs successifs de façon à ce qu'un sous-ensemble regroupe les amplificateurs les plus puissants du groupe tandis que l'autre regroupe les amplificateurs les moins puissants du groupe. Les sorties des amplificateurs B(1) à B(N/2) sont interconnectées à un plot PAD2 et les sorties des amplificateurs B(N/2 + 1) à B(N) sont interconnectées à un plot PAD3.

Une telle configuration permet d'utiliser un circuit d'émission (ou d'amplification) 4 soit pour un montage dans lequel les bornes RFO1 et RFO2 sont couplées à deux bornes d'une antenne (différentielle) recevant des amplificateurs du circuit 4 un signal différentiel, soit pour un montage dans lequel les bornes RFO1 et RFO2 sont couplées à une borne d'une antenne non différentielle ou cadre (single-ended ou frame) différente, dont l'autre borne est reliée, de préférence connectée, à la masse. Il suffit, lors de l'assemblage du circuit intégré formant le contrôleur 3 et intégrant le circuit 4, de souder les plots PAD1 et PAD3 respectivement aux bornes RFO1 et RFO2, et de souder le plot PAD2 soit à la borne RFO1 soit à la borne RFO2. Ainsi, l'amplificateur fonctionne soit avec des bornes RFO1 et RFO2 fournissant des gains d'amplification différents, soit avec des bornes fournissant le même gain d'amplification (rapport 1) sur les deux bornes RFO1 et RFO2.

Plus précisément, pour un montage à une antenne différentielle, le plot PAD1 est soudé à la borne RFO1 et les plots PAD2 et PAD3 sont soudés à la borne RFO2. Ainsi, chaque borne reçoit la même puissance.

Par contre, pour un montage à deux antennes non différentielles différentes (par exemple, l'antenne GSM du téléphone et une antenne plus grosse en face arrière du téléphone), on peut connecter les plots PAD1 et PAD2 à la borne RFO1 et connecter le plot PAD3 à la borne RFO2. Ainsi, l'antenne de relative petite taille destinée au mode carte, qui n'a besoin de ne recevoir qu'une relative faible puissance pour l'émission en modulation de charge active, est alimentée par les amplificateurs les moins puissants du groupe B tandis que l'antenne plus grande destinée au mode lecteur, pour laquelle on souhaite une puissance plus importante, exploite non seulement tous les amplificateurs du groupe A mais également les amplificateurs les plus puissants du groupe B.

Les entrées des amplificateurs A(i) et B(i) sont généralement individuellement commandées par des signaux provenant d'un étage d'entrée 42 (INPUT STAGE) du circuit 4 recevant les signaux Tx à transmettre et la porteuse f. Toutefois, on peut ici également prévoir d'interconnecter toutes les entrées des amplificateurs A(i) et les entrées des amplificateurs B(i), dans l'exemple de la figure 3, par moitié (les entrées des amplificateurs B(1) à B(N/2) étant interconnectées et les entrées des amplificateurs B(N/2+1) à B(N) étant interconnectées). Dans ce cas, l'étage d'entrée 42 intègre un sélecteur interconnectant les entrées des amplificateurs B(1) à B(N/2) soit avec les entrées des amplificateurs A(i) du groupe A, soit avec les entrées des amplificateurs B(N/2+1) à B(N).

Cela revient à rendre la moitié des 2N amplificateurs commandables ensemble, les amplificateurs restants étant soit commandables ensemble, soit commandables séparément par sous-ensembles, l'un des sous-ensembles étant alors commandé avec la (première) moitié d'amplificateurs.

Ainsi, selon la structure antennaire prévue dans le dispositif dans lequel est monté le contrôleur NFC 3, il suffit de connecter de façon adaptée les plots PAD1, PAD2 et PAD3 aux bornes RFO1 et RFO2 (représentant des bornes d'entrées d'un ou de deux circuits d'adaptation d'impédance entre le contrôleur 3 et la ou les antennes selon le cas).

Le choix des rapports résistifs (ou rapports de puissance) d'un amplificateur au suivant dans chaque groupe A ou B peut être fait de différentes façons et dépend des puissances souhaitées dans l'application.

On pourra par exemple effectuer une répartition à partir de simulations effectuées dans un mode et dans l'autre avec les différentes tailles d'antennes possibles.

Selon un autre exemple, on utilise un modèle équivalent d'un fonctionnement en mode différentiel et en mode non différentiel pour déterminer l'impact des résistances des amplificateurs élémentaires.

Selon encore un autre exemple, on peut considérer, qu'au premier ordre, le courant Irms dans une antenne avec un montage différentiel (groupe A sur une entrée de l'antenne et groupe B sur l'autre entrée de l'antenne) peut s'écrire :

$$Irms = \frac{2\sqrt{2}}{\pi} \times \frac{VDD\_RF}{R_{RFO1} + R_{RFO2} + R_{LOAD}} \quad ,$$

avec VDD_RF représentant la tension d'alimentation des amplificateurs, $R_{RFO1}$ représentant la résistance série équivalente des amplificateurs couplés à la borne RFO1, $R_{RFO2}$ représentant la résistance série équivalente des amplificateurs couplés à la borne RFO2, et $R_{LOAD}$ représentant la résistance équivalente des circuits (réseau d'adaptation et antenne) connectés aux bornes RFO1 et RFO2.

La puissance Pload fournie à la charge (donc à l'antenne) peut s'écrire :

$$Pload = R_{LOAD} \times \left( \frac{2\sqrt{2}}{\pi} \times \frac{VDD\_RF}{R_{RFO1} + R_{RFO2} + R_{LOAD}} \right)^2 \quad .$$

De même, on peut considérer, qu'au premier ordre, les courants Irms1 et Irms2 dans des antennes non différentielles avec un montage non différentiel (groupe A et une partie du groupe B sur la borne RFO1 et le reste du groupe B sur la borne RFO2) peuvent s'écrire :

$$Irms1 = \frac{\sqrt{2}}{\pi} \times \frac{VDD\_RF}{R_{RFO1} + R_{LOAD}} \quad ,$$

et

$$Irms2 = \frac{\sqrt{2}}{\pi} \times \frac{VDD\_RF}{R_{RFO2} + R_{LOAD}} \quad .$$

Les puissances Pload1 et Pload2 fournies aux antennes peuvent s'écrire :

$$Pload1 = R_{LOAD} \times \left( \frac{\sqrt{2}}{\pi} \times \frac{VDD\_RF}{R_{RFO1} + R_{LOAD}} \right)^2 \quad ,$$

et

$$Pload2 = R_{LOAD} \times \left( \frac{\sqrt{2}}{\pi} \times \frac{VDD\_RF}{R_{RFO2} + R_{LOAD}} \right)^2 \quad .$$

Il est donc possible, à partir de ces formules et en tenant compte du rapport de résistance entre les différents amplificateurs d'un même groupe, de répartir les amplificateurs du groupe B en deux sous-ensembles adaptés au mode non différentiel. Pour le mode différentiel, on reste avec une répartition groupe A sur une voie et groupe B sur l'autre voie en bénéficiant du fait que les deux groupes A et B sont identiques.

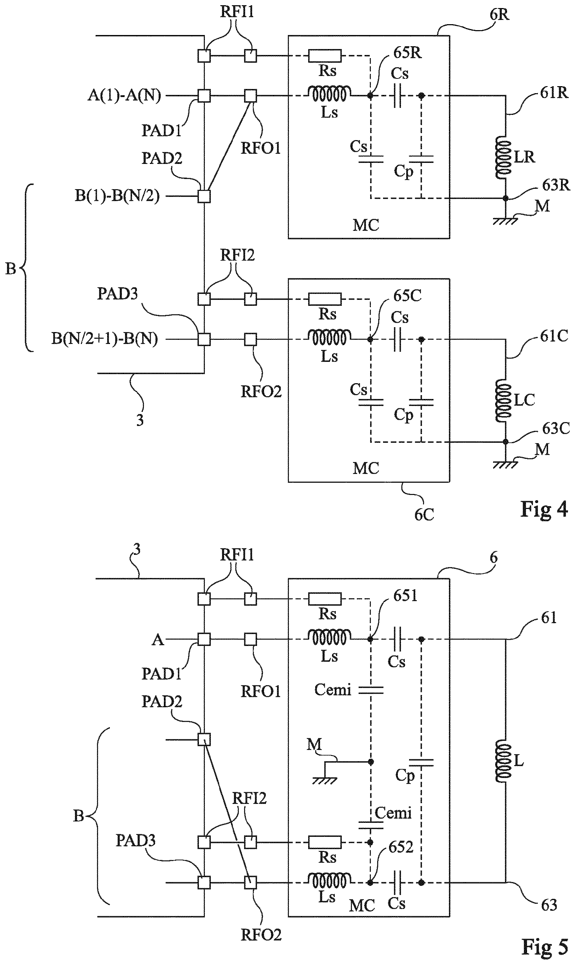

A titre d'exemple particulier de réalisation, on a réalisé une structure du type de celle représentée en figure 3 avec des groupes A et B de huit amplificateurs chacun (N = 8), chaque amplificateur ou segment d'amplification ayant une résistance en série double par rapport à l'amplificateur précédent (binary weighted). Avec des résistances de valeurs respectives approximatives de 1,4 ohms, 2,8 ohms, 5,4 ohms, 11 ohms, 21 ohms, 41 ohms, 82 ohms et 162 ohms, lorsque tous les amplificateurs d'un groupe sont utilisés, on peut considérer que la résistance équivalente du groupe est approximativement égale à la moitié de la résistance la plus faible, soit environ 0,7 ohms. Or, en mode carte dans un montage non différentiel, on n'a pas besoin d'une telle puissance. On peut donc réduire le nombre d'amplificateurs affectés au mode carte, c'est-à-dire couplés à la borne RFO2. Par exemple, on n'utilise que la moitié des amplificateurs B(i), ceux apportant le gain le plus faible (les amplificateurs B(N/2 + 1) à B(N), figure 4). Ainsi, les amplificateurs les plus forts (B(1) à B(N/2)) peuvent être affectés au mode lecteur en étant couplés à la borne RFO1, ce qui réduit encore la résistance série. Avec l'exemple numérique mentionné ci-dessus, la résistance équivalente de la voie RFO1 est approximativement de 11 ohms (la moitié de la résistance série de l'amplificateur B(5)) et celle de la voie RF02 est approximativement de 0,4 ohms, grâce à la contribution de l'amplificateur B(1).

D'autres répartitions sont bien entendu possibles.

Par ailleurs, bien qu'une distribution des amplificateurs élémentaires avec des pondérations binaires (doublement approximatif du gain d'un amplificateur au suivant) a été décrite, on pourra prévoir d'autres distributions, voire des amplificateurs élémentaires tous identiques. Dans ce cas, l'écart de résistance série entre les modes lecteur et carte en mode non différentiel est moins important.

La figure 4 représente, de façon très schématique et sous forme de blocs, un exemple de raccordement d'un contrôleur NFC 3 dans un dispositif à deux antennes LR et LC respectivement dédiées au mode lecteur et au mode carte.

Chaque antenne LR, LC est associée à un circuit 6R, 6C d'adaptation d'impédance (MC) la reliant au contrôleur 3. Plus précisément, une première borne 61R de l'antenne LR est raccordée, par le circuit 6R d'adaptation d'impédance, aux bornes RFI1 et RFO1, une deuxième borne 63R de l'antenne LR étant reliée, de préférence connectée, à la masse M. Une première borne 61C de l'antenne LC est raccordée, par le circuit 6C d'adaptation d'impédance, aux bornes RF02 et RFI2, une deuxième borne 63C de l'antenne LC étant reliée, de préférence connectée, à la masse M. La figure 4 reprend l'exemple de la figure 3 dans lequel le groupe B est divisé par moitié en deux sous-ensembles, les amplificateurs élémentaires les plus forts étant couplés à la borne RFO1. La borne RFO1 est ainsi reliée, de préférence connectée, aux bornes ou plots PAD1 et PAD2 du contrôleur 3 tandis que la borne RFO2 est reliée, de préférence connectée, à la borne ou plot PAD3 du contrôleur 3.

La figure 4 illustre également des exemples de circuits 6R et 6C d'adaptation d'impédance (MC) faisant ressortir leurs structures similaires. Il ne s'agit que d'un exemple illustré en pointillés et tout circuit d'adaptation d'impédance peut convenir. Chaque circuit 6R, 6C comporte une capacité Cp en parallèle sur l'antenne correspondante, c'est-à-dire reliée, de préférence connectée, aux bornes 61R, respectivement 61C, et 63R, respectivement 63C. Les bornes 61R et 63R, respectivement 61C et 63C, sont chacune reliées, par une capacité Cs, à un nœud commun 65R, respectivement 65C. Le nœud 65R, respectivement 65C, est relié par un élément inductif Ls à la borne RFO1, respectivement RFO2, et par un élément résistif Rs à la borne RFI1, respectivement RFI2. Le fonctionnement du circuit d'adaptation d'impédance est en lui-même usuel.

La figure 5 représente, de façon très schématique et sous forme de blocs, un exemple de raccordement d'un contrôleur NFC 3 dans un dispositif à une antenne différentielle L.

L'antenne L est associée à un circuit 6 d'adaptation d'impédance (MC) la reliant au contrôleur 3. Plus précisément, une première borne 61 de l'antenne L est reliée, par le circuit 6, aux bornes RFI1 et RFO1 et une deuxième borne 63 de l'antenne L est reliée, par le circuit 6, aux bornes RF02 et RFI2. Pour que les puissances d'amplification du signal soient les mêmes sur chaque voie différentielle en émission (rapport 1), la borne RFO1 est reliée, de préférence connectée, à la borne ou plot PAD1 du contrôleur 3 tandis que la borne RFO2 est reliée, de préférence connectée, aux bornes ou plots PAD2 et PAD3 du contrôleur 3.

La figure 5 illustre également un exemple de circuit d'adaptation 6 (MC) faisant ressortir sa structure similaire sur chaque voie différentielle. Il ne s'agit que d'un exemple illustré en pointillés et tout circuit d'adaptation d'impédance peut convenir. Le circuit 6 comporte une capacité Cp en parallèle sur l'antenne 6, c'est-à-dire reliée, de préférence connectée, aux bornes 61 et 63. Les bornes 61 et 63 sont chacune reliées, par une capacité Cs, à un nœud 651, respectivement 652. Chaque nœud 651, 652 est relié par un élément inductif Ls à la borne RFO1, respectivement RFO2, et par un élément résistif Rs à la borne RFI1, respectivement RFI2. Par ailleurs, les nœuds 651 et 652 sont chacun reliés, par une capacité Cemi, à la masse M. Le fonctionnement du circuit d'adaptation d'impédance est là encore en lui-même usuel.

La connexion des plots PAD1, PAD2 et PAD3 aux bornes RFO1 et RFO2 s'effectue lors de la fabrication, par exemple lors de la mise en boîtier (packaging) du contrôleur NFC. En effet, en fonction du dispositif NFC auquel le contrôleur 3 est destiné, on sait à ce moment-là s'il est destiné à fonctionner en mode différentiel ou non-différentiel. En variante, cette connexion s'effectue lors de l'assemblage des circuits du dispositif NFC. Cependant, cette connexion est définitive et s'effectue donc par soudure. En effet, un des objectifs est de réduire l'encombrement et donc d'éviter un commutateur.

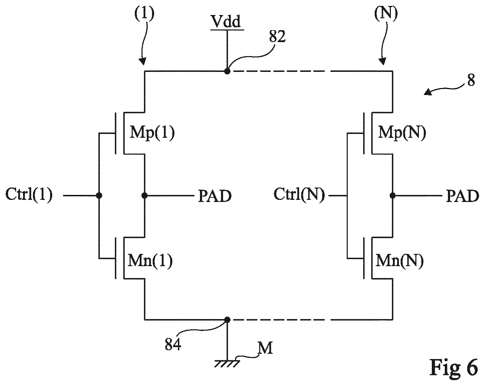

La figure 6 représente un mode de réalisation d'un circuit d'amplification à plusieurs amplificateurs élémentaires.

La figure 6 représente un exemple d'amplificateur 8 pouvant constituer le groupe A ou B d'amplificateurs élémentaires de la figure 3. Dans cet exemple, on suppose un amplificateur de classe D dans lequel chaque amplificateur élémentaire (i), i étant compris entre 1 et N, comporte deux transistors MOS Mp(i) et Mn(i) en série entre deux bornes 82 et 84 d'application d'une tension positive Vdd référencée à la masse M (borne 84). Tous les amplificateurs élémentaires (i) sont en parallèle entre les bornes 82 et 84. Les grilles de chaque transistor de chaque amplificateur élémentaire (i) sont interconnectées à une borne de commande Ctrl(i) reliée à l'étage d'entrée (42, figure 3). Le point milieu de l'association en série des transistors Mp(i) et Mn(i) de chaque amplificateur élémentaire (i) est relié, de préférence connecté, au plot de sortie PAD correspondant au groupe A ou au demi-groupe du groupe B auquel il appartient. Ainsi, la réalisation d'un circuit d'amplification 4 compatible avec un montage en mode différentiel ou en mode non différentiel est particulièrement simple.

Un avantage des modes de réalisation décrits est qu'ils permettent de proposer un contrôleur NFC compatible avec deux types de fonctionnement différents du point de vue de son raccordement à la ou aux antennes, sans pour autant nécessiter de transformateur à changement de mode ou de commutateur d'antenne.

Un avantage des modes de réalisation décrits est qu'ils permettent donc de réduire l'encombrement des circuits d'émission d'un dispositif NFC.

Divers modes de réalisation ont été décrits. Diverses modifications apparaîtront à l'homme de l'art. En particulier, le dimensionnement des circuits d'adaptation d'impédance et des amplificateurs du contrôleur NFC dépend de l'application. En outre, la mise en oeuvre pratique des modes de réalisation qui ont été décrits est à la portée de l'homme du métier en utilisant les indications fonctionnelles données ci-dessus.

## Revendications

1. Circuit d'amplification (4) comportant deux groupes (A ; B) d'un même nombre (N) de plusieurs amplificateurs (A(i) ; B(i)), toutes les sorties d'amplificateurs d'un premier groupe étant interconnectées à une première borne (PAD1) de sortie du circuit d'amplification, les sorties d'amplificateurs d'un deuxième groupe étant réparties en deux sous-ensembles d'un même nombre d'amplificateurs, respectivement interconnectées à des deuxième (PAD2) et troisième (PAD3) bornes de sortie du circuit d'amplification.

2. Circuit selon la revendication 1, dans lequel chaque groupe (A, B) d'amplificateurs est identique.

3. Circuit selon la revendication 1 ou 2, dans lequel les amplificateurs (A(i) ; B(i)) d'un même groupe (A ; B) sont de puissances différentes.

4. Circuit selon la revendication 3, dans lequel les deux sous-ensembles (B(1), ..., B(N/2) ; B(N/2+1), ..., B(N)) d'amplificateurs (B(i)) du deuxième groupe (B) sont de puissances différentes.

5. Circuit selon l'une quelconque des revendications 1 à 4, dans lequel les amplificateurs (A(1), ..., A(N)) du premier groupe (A) sont commandables ensemble, les amplificateurs (B(1), ..., B(N/2); B (N/2+1), ..., B(N)) des deux sous-ensembles du deuxième groupe étant soit commandables ensemble, soit commandables séparément, l'un (B(1), ..., B(N/2)) des sous-ensembles étant alors commandé avec le premier groupe d'amplificateurs.

6. Circuit selon l'une quelconque des revendications 1 à 5, dans lequel chaque amplificateur (A(i), B(i)) est de classe D.

7. Contrôleur NFC (3) comportant au moins un circuit d'amplification (4) selon l'une quelconque des revendications 1 à 6.

8. Contrôleur NFC selon la revendication 7, comportant deux sorties (RFO1, RFO2), dans lequel le rapport entre les puissances respectives fournies par les deux sorties est de 1 si les deuxième (PAD2) et troisième (PAD3) bornes du circuit d'amplification (4) sont interconnectées et est différent de 1 si les première (PAD1) et deuxième (PAD2) bornes du circuit d'amplification sont interconnectées.

9. Circuit d'émission-réception NFC comportant un contrôleur (3) selon la revendication 7 ou 8.

10. Circuit selon la revendication 9, comportant :

   un circuit (6) d'adaptation d'impédance ; et
   une antenne (L) à entrées différentielles.

11. Circuit selon la revendication 10, dans lequel les deuxième (PAD2) et troisième (PAD3) bornes du circuit d'amplification (4) sont interconnectées.

12. Circuit selon la revendication 9, comportant :

   deux circuits (6R, RC) d'adaptation d'impédance ; et

deux antennes (LR, LC) ayant chacune une entrée non-différentielle (61R ; 61C) et une borne (63R ; 63C) reliée à une masse (M).

13. Circuit selon la revendication 12, dans lequel les première (PAD1) et deuxième (PAD2) bornes du circuit d'amplification (4) sont interconnectées.

14. Dispositif NFC (1, 2) comportant au moins un circuit selon l'une quelconque des revendications 9 à 13.

**Patentansprüche**

1. Verstärkerschaltung (4), die zwei Gruppen (A; B) einer gleichen Anzahl (N) von mehreren Verstärkern (A(i); B(i)) aufweist, wobei alle Ausgänge von Verstärkern einer ersten Gruppe mit einem ersten Ausgangsanschluss (PAD1) der Verstärkerschaltung verbunden sind und die Ausgänge von Verstärkern einer zweiten Gruppe auf zwei Untergruppen einer gleichen Anzahl von Verstärkern verteilt sind, die jeweils mit einem zweiten (PAD2) und einem dritten (PAD3) Ausgangsanschluss der Verstärkerschaltung verbunden sind.

2. Schaltung nach Anspruch 1, wobei jede Gruppe (A, B) von Verstärkern identisch ist.

3. Schaltung nach Anspruch 1 oder 2, bei der die Verstärker (A(i); B(i)) einer gleichen Gruppe (A; B) unterschiedliche Leistungen haben.

4. Schaltung nach Anspruch 3, bei der die beiden Untergruppen (B(1), ..., B(N/2); B(N/2+1), ..., B(N)) von Verstärkern (B(i)) der zweiten Gruppe (B) unterschiedliche Leistungen haben.

5. Schaltung nach einem der Ansprüche 1 bis 4, wobei die Verstärker (A(1), ..., A(N)) der ersten Gruppe (A) gemeinsam steuerbar sind, die Verstärker (B(1), ..., B(N/2); B(N/2+1), ... , B(N)) der beiden Untergruppen der zweiten Gruppe entweder gemeinsam oder getrennt steuerbar sind, wobei dann eine (B(1), ..., B(N/2)) der Untergruppen mit der ersten Gruppe von Verstärkern gesteuert wird.

6. Schaltung nach einem der Ansprüche 1 bis 5, wobei jeder Verstärker (A(i), B(i)) zur Klasse D gehört.

7. Nahfeldkommunikations- bzw. NFC-Steuergerät (3) mit mindestens einer Verstärkerschaltung (4) nach einem der Ansprüche 1 bis 6.

8. NFC-Steuergerät nach Anspruch 7, das zwei Ausgänge (RFO1, RFO2) aufweist, wobei das Verhältnis der jeweiligen von den beiden Ausgängen gelieferten Leistungen 1 ist, wenn der zweite (PAD2) und der dritte (PAD3) Anschluss der Verstärkerschaltung (4) miteinander verbunden sind, und von 1 verschieden ist, wenn der erste (PAD1) und der zweite (PAD2) Anschluss der Verstärkerschaltung miteinander verbunden sind.

9. NFC-Transceiver-Schaltung mit dem Steuergerät (3) nach Anspruch 7 oder 8.

10. Schaltung nach Anspruch 9, die Folgendes aufweist:

   eine Impedanzanpassungsschaltung (6); und
   eine Antenne (L) mit Differenzeingängen.

11. Schaltung nach Anspruch 10, wobei der zweite (PAD2) und der dritte (PAD3) Anschluss der Verstärkerschaltung (4) miteinander verbunden sind.

12. Schaltung nach Anspruch 9, die Folgendes aufweist:

   zwei Impedanzanpassungsschaltungen (6R, RC); und
   zwei Antennen (LR, LC), von denen jede einen nicht-differentiellen Eingang (61R; 61C) und einen mit Masse (M) gekoppelten Anschluss (63R; 63C) aufweist.

13. Schaltung nach Anspruch 12, wobei der erste (PAD1) und der zweite (PAD2) Anschluss der Verstärkerschaltung (4) miteinander verbunden sind.

**14.** NFC-Vorrichtung (1, 2) mit mindestens einer Schaltung nach einem der Ansprüche 9 bis 13.

**Claims**

**1.** An amplification circuit (4) comprising two groups (A; B) of a same number (N) of several amplifiers (A(i); B(i)), all outputs of amplifiers of a first group being interconnected to a first output terminal (PAD1) of the amplification circuit, the outputs of amplifiers of a second group being distributed into two sub-assemblies of a same number of amplifiers, respectively interconnected to second (PAD2) and third (PAD3) output terminals of the amplification circuit.

**2.** The circuit of claim 1, wherein each group (A, B) of amplifiers is identical.

**3.** The circuit of claim 1 or 2, wherein the amplifiers (A(i); B(i)) of a same group (A; B) have different powers.

**4.** The circuit of claim 3, wherein the two sub-assemblies (B(1), ..., B(N/2); B(N/2+1), ..., B(N)) of amplifiers (B(i)) of the second group (B) have different powers.

**5.** The circuit of any of claims 1 to 4, wherein the amplifiers (A(1), ..., A(N)) of the first group (A) are controllable together, the amplifiers (B(1), ..., B(N/2); B(N/2+1), ..., B(N)) of the two sub-assemblies of the second group being either controllable together, or separately controllable, one (B(1), ..., B(N/2)) of the sub-assemblies being then controlled with the first group of amplifiers.

**6.** The circuit of any of claims 1 to 5, wherein each amplifier (A(i), B(i)) is of class D.

**7.** A NFC controller (3) comprising at least one amplification circuit (4) of any of claims 1 to 6.

**8.** The NFC controller of claim 7, comprising two outputs (RFO1, RFO2), wherein the ratio of the respective powers supplied by the two outputs is 1 if the second (PAD2) and third (PAD3) terminals of the amplification circuit (4) are interconnected and is different from 1 if the first (PAD1) and second (PAD2) terminals of the amplification circuit are interconnected.

**9.** A NFC transceiver circuit comprising the controller (3) of claim 7 or 8.

**10.** The circuit of claim 9, comprising:

an impedance matching circuit (6); and
an antenna (L) having differential inputs.

**11.** The circuit of claim 10, wherein the second (PAD2) and third (PAD3) terminals of the amplification circuit (4) are interconnected.

**12.** The circuit of claim 9, comprising:

two impedance matching circuits (6R, RC); and
two antennas (LR, LC), each having a non-differential input (61R; 61C) and a terminal (63R; 63C) coupled to a ground (M) .

**13.** The circuit of claim 12, wherein the first (PAD1) and second (PAD2) terminals of the amplification circuit (4) are interconnected.

**14.** A NFC device (1, 2) comprising at least one circuit of any of claims 9 to 13.

Fig 1

Fig 2

Fig 3

Fig 4

Fig 5

Fig 6

**RÉFÉRENCES CITÉES DANS LA DESCRIPTION**

**Documents brevets cités dans la description**

- US 2009201084 A